(19) Europäisches Patentamt
European Patent Office
Office européen des brevets

(11) EP 1 705 701 A2

# (12) EUROPEAN PATENT APPLICATION

(43) Date of publication:
27.09.2006 Bulletin 2006/39

(21) Application number: 06005984.7

(22) Date of filing: 23.03.2006

(51) Int Cl.:
*H01L 21/321* (2006.01) *C09G 1/02* (2006.01)
*H01L 21/768* (2006.01)

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: 23.03.2005 JP 2005083471

(71) Applicant: **FUJI PHOTO FILM CO., LTD.**
**Minami-Ashigara-shi, Kanagawa (JP)**

(72) Inventor: **Akatsuka, Tomohiko**
**Fuji Photo Film Co., Ltd.**
**Haibara-gun**
**Shizuoka (JP)**

(74) Representative: **HOFFMANN EITLE**
**Patent- und Rechtsanwälte**
**Arabellastrasse 4**
**81925 München (DE)**

## (54) Chemical and mechanical polishing method and polishing liquid used therefor

(57) A polishing method comprising chemically and mechanically polishing a surface to be polished, the polishing comprising a plurality of steps, wherein the surface is polished with a polishing liquid containing an oxidant in each of the plurality of steps, and the polishing liquids used for the each of the steps are different only in a concentration of the oxidant and satisfy the following expression (1) : $R_{n-1} > R_n$ (1), wherein $R_n$ represents a polishing rate of the surface to be polished in $n^{th}$ step, $R_{n-1}$ represents a polishing rate of the surface to be polished in n-$1^{th}$ step, and n represents an integer of 2 or more.

EP 1 705 701 A2

## Description

### FIELD OF THE INVENTION

The present invention relates to the manufacture of a semiconductor device, in particular relates to a chemical and mechanical polishing method using a polishing liquid for metals in the wiring process of a semiconductor device.

### BACKGROUND OF THE INVENTION

CMP process now used in a forming process of metallic wiring of a semiconductor device is required to have high flatness from the problem of the depth of focus of a developing machine in a process of wiring laid on the upper portion. In the same process, a phenomenon that a dish-like concavity is formed due to excess polishing of a wiring portion than the upper face of an insulating film, i.e., dishing, brings about a problem as the main cause to deteriorate flatness. The most general means for suppressing the dishing is a means of using a compound restraining the progressing speed of dishing, that is, an etching inhibitor. However, there is a positive correlation between an etching rate and a polishing rate, so that it is necessary to greatly reduce a polishing rate to suppress the dishing. That is, a polishing rate should be sacrificed in many cases for obtaining high flatness, which leads to the increase of processing time to thereby decrease manufacturing efficiency of semiconductor devices.

As a means to reconcile high flatness with processing time in the polishing of copper wiring, there is a case of taking a means of dividing a polishing process to several steps, and performing polishing in the first place with a polishing liquid of a high polishing rate although a flattening property is inferior, subsequently performing polishing for finishing with a polishing liquid capable of obtaining high flatness although a polishing rate is slow. Conventional polishing liquids are greatly different in composition in each step, so that polishing liquids and feeders are necessary as much as the numbers of steps, and feeding system and control become complicated.

There is disclosed in JP-A-2002-64070 (corresponding to U.S. Patent 6,599,173) a method comprising a step of removing excess metal on the surface of a wafer with a first oxidant, and a step of removing the metal residue with a second oxidant having a higher affinity than the first oxidant. A polishing method of performing a process not containing an oxidant after a process of using a polishing liquid containing an oxidant in a CMP process of metal wiring is disclosed in JP-A-11-345792. A method of reducing the dishing and erosion in a process of forming Damascene wiring is disclosed in JP-A-2001-257188.

### SUMMARY OF THE INVENTION

The invention provides a polishing method capable of varying polishing property by changing only the concentration of an oxidant in a process of polishing metal wiring of a copper and alloys containing a copper as a main component in the manufacturing process of semiconductor wiring, and capable of realizing high flatness and efficiently finishing high grade metal wiring while maintaining a simple feeding system of a polishing liquid. That is, the invention provides a polishing method capable of controlling a polishing rate and flattening property by changing only the oxidant concentration without modifying the composition other than an oxidant of a polishing liquid for metals.

As a result of eager investigation of the above problems of a polishing liquid for metals, the present inventor found that the above problems could be solved with the following polishing liquid, thus the object of the invention has been achieved.

That is, the invention is as follows.

(1) A chemical and mechanical polishing method comprising chemically and mechanically polishing the surface to be polished by dividing the process of polishing into a plurality of steps with a polishing liquid containing an oxidant, wherein the polishing liquids used for the plurality of steps are different only in the concentration of the oxidant and satisfy the following expression (1):

$$R_{n-1} > R_n \qquad (1)$$

wherein $R_n$ represents the polishing rate of the surface to be polished in the $n^{th}$ step, $R_{n-1}$ represents the polishing rate of the surface to be polished in the $n\text{-}1^{th}$ step, and n represents an integer of 2 or more.

(2) The chemical and mechanical polishing method as described in the above item (1), wherein the polishing liquids satisfy the following expression (2):

$$C_{n-1} < C_n \quad (2)$$

wherein $C_n$ represents the concentration of the oxidant in the $n^{th}$ step, and $C_{n-1}$ represents the concentration of the oxidant in the $n\text{-}1^{th}$ step.

(3) The chemical and mechanical polishing method as described in the above item (1) or (2), wherein the oxidant is any one of hydrogen peroxide, peroxide, nitrate, iodate, periodate, hypochlorite, chlorite, chlorate, perchlorate, persulfate, dichromate, permanganate, ozone water, silver (II) salt, and iron(III) salt.

(4) The chemical and mechanical polishing method as described in the above item (1), (2) or (3), wherein the polishing liquid contains at least any one of a compound represented by formula (1) and a compound represented by formula (2):

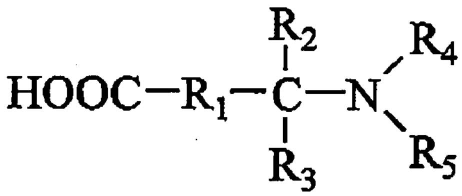

(1)

wherein $R_1$ represents a single bond, an alkylene group or a phenylene group; $R_2$ and $R_3$ each independently represents a hydrogen atom, a halogen atom, a carboxyl group, an alkyl group, a cycloalkyl group, an alkenyl group, an alkynyl group, or an aryl group; $R_4$ and $R_5$ each independently represents a hydrogen atom, a halogen atom, a carboxyl group, an alkyl group, or an acyl group; provided that when $R_1$ represents a single bond, at least either $R_4$ or $R_5$ does not represent a hydrogen atom;

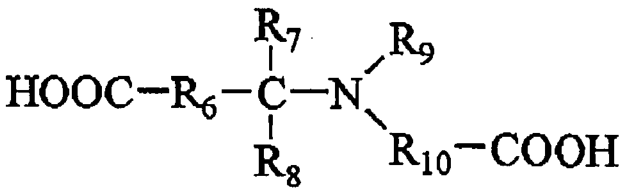

(2)

wherein $R_6$ represents a single bond, an alkylene group or a phenylene group; $R_7$ and $R_8$ each independently represents a hydrogen atom, a halogen atom, a carboxyl group, an alkyl group, a cycloalkyl group, an alkenyl group, an alkynyl group, or an aryl group; $R_9$ represents a hydrogen atom, a halogen atom, a carboxyl group, or an alkyl group; $R_{10}$ represents an alkylene group; provided that when $R_{10}$ represents $-CH_2-$, at least either $R_6$ is not a single bond, or $R_9$ is not a hydrogen atom.

(5) The chemical and mechanical polishing method as described in any of the above items (1) to (4), wherein the polishing liquid further contains abrasive grains.

(6) The chemical and mechanical polishing method as described in any of the above items (1) to (5), wherein the surface to be polished is a surface containing at least one compound selected from the compounds respectively containing copper, a copper alloy, and tantalum.

(7) A polishing liquid not containing an oxidant which is used in the polishing method as described in any of the items (1) to (6).

The polishing method in the invention is a polishing method capable of controlling a polishing rate and flattening property by changing only the oxidant concentration without modifying the composition other than an oxidant of a polishing liquid for metals. Accordingly, the polishing that makes efficient high flattening possible can be realized while maintaining a simple feeding system of a polishing liquid, so that the polishing method in the invention has wide application as follows.

In many polishing liquid feeders now used, stock solutions of polishing liquid for metals and oxidant are fed under pressure to a mixing tank and mixed there. If necessary, the polishing liquid is diluted with pure water and the like. The prepared polishing liquid is fed under pressure into a polisher. That is, in many conventional methods, the same number of stock solution tanks of polishing liquids and mixing tanks as the number of steps of polishing are necessary.

In the invention, a metal polishing liquid in each step is prepared by changing the mixing ratio of a metal polishing liquid stock solution of the composition exclusive of oxidant and an oxidant stock solution, and if necessary, by dilution.

That is, according to the invention, even if the polishing step comprises a plurality of steps, the tanks of stock solutions required are only two kinds, so that the installation space of stock solution tanks can be saved and simplification of the control of stock solution tanks can be expected.

Further, when the feed line between a stock solution tank and the feed port of a polisher is equipped a small mixing cell capable of mixing a polishing liquid and an oxidant while feeding under pressure, further simplification of a feed system is possible. That is, if it is possible to change the ratio of a feeding rate of a polishing liquid and a feeding rate of an oxidant to the mixing cell, the execution of the invention becomes possible. Further, it is possible to continuously change the concentration of oxidant by continuously changing the ratio of these feed rates, that is, it becomes possible to continuously changing flattening property.

Further, when a system capable of measuring the thickness of copper and a copper alloy during polishing is used, it is possible to further efficiently realize high grade polishing by switching the polishing step according to the thickness.

In addition, when the number of platens and the number of polishing steps in a polisher are the same, polishing can be carried out by the assignment of one kind of slurry to one platen, but when the number of platens is less than the number of polishing steps, one platen takes charge of a plurality of steps, i.e., slurries. In such a case, since conventional slurries are greatly different in the compositions of polishing liquids in every step, in particular when a physical property such as pH is different, two kinds of slurries are mixed and coagulation of abrasive grains is caused, or solid salts occur, which cause defects such as scratches on the surface to be polished in many cases. For reducing such influences, it is necessary to initialize the surface of the pad before going to the next step by performing water polish and dressing between steps, as a result, the total processing time is further elongated.

However, since the compositions of the slurries of the invention are equal except for the oxidants, there are no possibilities of the occurrence of defect sources even when continuous steps are taken, so that water polish and dressing can be omitted, and it becomes possible to continuously change processing characteristics without being accompanied by the elongation of processing time.

## DETAILED DESCRIPTION OF THE INVENTION

The chemical and mechanical polishing method in the invention comprises chemically and mechanically polishing the surface to be polished by dividing the process of polishing into a plurality of steps with a polishing liquid containing an oxidant, wherein the polishing liquids used in the each of the plurality of steps are different only in the concentration of the oxidant (a first polishing liquid used in one of the plurality of steps is different only in the concentration of the oxidant from another polishing liquid used in another step) and satisfies the following expression (1) with the polishing rate of the surface to be polished in the $n^{th}$ step as $R_n$:

$$R_{n-1}>R_n \qquad (1)$$

In addition, it is preferred that the relationship in the following expression (2) forms with the concentration of the oxidant in the $n^{th}$ step as $C_n$:

$$C_{n-1}<C_n \qquad (2)$$

A polishing rate R is a value obtained by measuring the film thickness before polishing in the $n^{th}$ step and the film thickness after polishing and dividing the difference in film thickness by the polishing time in the $n^{th}$ step.

The film thickness t was found by measuring the surface resistance value of the metal thin film on the surface to be polished (ps $\Omega \cdot m^{-2}$) by the DC four probe method (JIS-K-7194) according to the following relational expression.

$$\rho = \rho s \cdot t$$

wherein $\rho$ is the resistance value of the metal ($\Omega \cdot m^{-1}$), and t is the thickness of the metal (m).

$\rho^-$ of various metals are well known, e.g., p of copper is $1.63 \times 10^{-8}\ \Omega \cdot m^{-1}$ (see Rikagaku Jiten, 5th Edition, Iwanami Shoten Publishers).

Oxidant concentration C is the concentration of the oxidant in a metal polishing liquid in polishing, and in the

case of concentrated liquid, the concentration C is the concentration of the oxidant after dilution in polishing.

The polishing method can be performed by forming a graph showing the relationship between the oxidant concentration of a polishing liquid for metals having a certain composition and the polishing rate, and using a polishing liquid for metals having prescribed oxidant concentration in the first step to the $n^{th}$ step so as to satisfy expression (1) and expression (2):

$$R_{n-1}>R_n \qquad (1)$$

$$C_{n-1}<C_n \qquad (2)$$

$R_{n-1}$-$R_n$ is preferably from 10 to 1,000 nm/min, and more preferably from 20 to 300 nm/min.

$[(C_n-C_{n-1})/C_{n-1}] \times 100$ (%) is preferably from 0.1 to 10%, and more preferably from 0.2 to 2.0%.

In the polishing method, n is preferably from 2 to 6, and more preferably 2 or 3.

The polishers that can be used for performing the polishing method in the invention are not especially restricted, and Mirra Mesa CMP, Reflexion CMP (Applied Materials), FREX200, FREX300 (Ebara Corporation), NPS3301, NPS2301 (Nikon Corporation), A-FP-310A, A-FP-210A (Tokyo-Seimitsu), 2300 TERES (Lam Research Corporation), and Momentum (Speedfam IPEC) can be exemplified.

The compositions of a polishing liquid for metals are described below, but the invention is not limited thereto.

The polishing liquid for metals in the invention contains at least an oxidant as the constituent, and is generally an aqueous solution.

The polishing liquid for metals in the invention may further contain other components, and as preferred components, e.g., abrasive grains, a compound added as a so-called film-forming agent, a surfactant, a water-soluble polymer, and additives are exemplified.

Each component contained in the polishing liquid for metals may be one kind, or two or more kinds may be used in combination.

An oxidant may be added to the composition containing other components immediately before use to be made a polishing liquid.

"Polishing liquid for metals" in the invention includes not only a polishing liquid for use in polishing (that is, a polishing liquid diluted according to necessity), but also the concentrated liquid of a polishing liquid for metals. The concentrated liquid or the concentrated polishing liquid means a polishing liquid prepared higher in solute concentration than the polishing liquid that is used for polishing, and it is diluted with water or an aqueous solution when used for polishing. The magnification of dilution is generally from 1 to 20 times the volume. In the present specification, "concentration" or "concentrated liquid" is used according to an idiomatic expression meaning "denser" or "a denser liquid" than a liquid in use condition, that is, this term is used in the meaning different from the common usage that is accompanied by physical concentrating operation, e.g., evaporation.

The constitutional components of the polishing liquid for metals are explained below.

<u>Oxidant</u>:

The polishing liquid for metals in the invention contains a compound (an oxidant) capable of oxidizing the metals of the object of polishing.

As the oxidants, e.g., hydrogen peroxide, peroxide, nitrate, iodate, periodate, hypochlorite, chlorite, chlorate, perchlorate, persulfate, dichromate, permanganate, ozone water, silver(II) salt, and iron(III) salt are exemplified.

As the iron (III) salts, inorganic iron (III) salts, e.g., iron(III) nitrate, iron (III) chloride, iron(III) sulfate, and iron (III) bromide, in addition, organic complex salts of iron(III) are preferably used.

When organic complex salts of iron (III) are used, as the complex-forming compounds constituting iron(III) complex salts, e.g., acetic acid, citric acid, oxalic acid salicylic acid, diethyldithiocarbamic acid, succinic acid, tartaric acid, glycolic acid, glycine, alanine, aspartic acid, thioglycolic acid, ethylenediamine, trimethylenediamine, diethylene glycol, triethylene glycol, 1,2-ethanedithiol, malonic acid, glutaric acid, 3-hydroxybutyric acid, propionic acid, phthalic acid, isophthalic acid, 3-hydroxysalicylic acid, 3,5-dihydroxysalicylic acid, gallic acid, benzoic acid, maleic acid, salts of these acids, and aminopolycarboxylic acid and salt thereof are exemplified.

As the aminopolycarboxylic acids and salts thereof, ethylenediamine-N,N,N',N'-tetraacetic acid, diethylenetriaminepentaacetic acid, 1,3-diaminopropane-N,N,N',N'-tetraacetic acid, 1,2-diaminopropane-N,N,N',N'-tetraacetic acid, ethylenediamine-N,N'-disuccinic acid (racemic body), athylenediaminedisuccinic acid (SS body), N-(2-carboxylatoethyl)-L-aspartic acid, N-(carboxymethyl)-L-aspartic acid, β-alaninediacetic acid, methyliminodiacetic acid, nitrilotriacetic acid, cyclohexanecuaminetetraacetic acid, iminodiacetic acid, glycol ether diaminetetraacetic acid, ethylenediamine 1-N,N'-diacetic acid, ethylenediamineorthohydroxyphenylacetic acid, N,N-bis(2-hydroxybenzyl)-ethylenediamine-N,N-diacetic acid, and salts thereof are exemplified.

As the kinds of counter salts, alkali metal salts and ammonium salts are preferred, and ammonium salts are especially preferred.

Of these oxidants, hydrogen peroxide, iodate, hypochlorite, chlorate, and organic complex salts of iron (III) are preferred. When organic complex salts of iron(III) are used, as the preferred complex-forming compounds, citric acid, tartaric acid, and aminopolycarboxylic acid (specifically, ethylenediamdne-N,N,N' ,N'-tetraacetic acid, diethylenetriaminepentaacetic acid, 1,3-diaminopropane-N,N,N' ,N'-tetraacetic acid, ethylenediamine-N,N'-disuccinic acid (racemic body), ethylenediaminedisuccinic acid (SS body), N-(2-carboxylatoethyl)-L-aspartic acid, N-(carboxymethyl)-L-aspartic acid, β-alaninediacetic acid, methyliminodiacetic acid, nitrilotriacetic acid, and iminodiacetic acid) are exemplified.

Of the oxidants, hydrogen peroxide, ethylenediamine-N,N,N',N'-tetraacetic acid, 1,3-diaminopropane-N,N,N', N'-tetraacetic acid, and ethylenediaminedisuccinic acid (SS body) of iron(III) are most preferred.

The addition amount of the oxidant is preferably from 0.003 to 8 mols in 1 liter of the polishing liquid for metals to be used in polishing, more preferably from 0.03 to 6 mols, and especially preferably from 0.1 to 4 mols. That is, the addition amount of the oxidant of 0.003 mols or more is preferred in view of ensuring sufficient oxidation of a metal and high CMP rate, and 8 mol or less is preferred for the prevention of roughening of the polished surface.

The polishing liquid preferably contains a compound represented by formula (1) or (2).

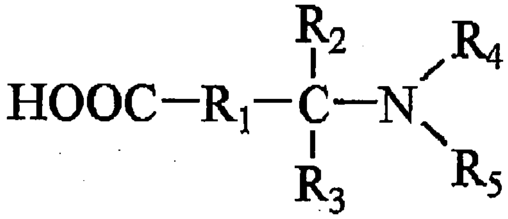

(1)

In formula (1), $R_1$ represents a single bond, an alkylene group or a phenylene group; $R_2$ and $R_3$ each independently represents a hydrogen atom, a halogen atom, a carboxyl group, an alkyl group, a cycloalkyl group, an alkenyl group, an alkynyl group, or an aryl group; and $R_4$ and $R_5$ each independently represents a hydrogen atom, a halogen atom, a carboxyl group, an alkyl group, or an acyl group, provided that when $R_1$ represents a single bond, at least either $R_4$ or $R_5$ does not represent a hydrogen atom.

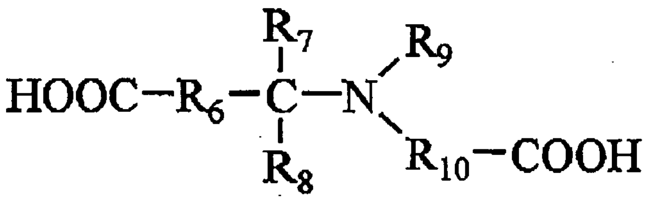

(2)

In formula (2), $R_6$ represents a single bond, an alkylene group or a phenylene group; $R_7$ and $R_8$ each independently represents a hydrogen atom, a halogen atom, a carboxyl group, an alkyl group, a cycloalkyl group, an alkenyl group, an alkynyl group, or an aryl group; $R_9$ represents a hydrogen atom, a halogen atom, a carboxyl group, or an alkyl group; and $R_{10}$ represents an alkylene group, provided that when $R_{10}$ represents $-CH_2-$, at least either $R_6$ is not a single bond, or $R_9$ is not a hydrogen atom.

In formula (1), the alkylene group represented by $R_1$ may be any of straight chain, branched, or cyclic, preferably an alkylene group having from 1 to 8 carbon atoms, e.g., a methylene group and an ethylene group are exemplified.

As the substituents that the alkylene group may have, a hydroxyl group and a halogen atom can be exemplified.

The alkyl group represented $R_2$ and $R_3$ is preferably an alkyl group having from 1 to 8 carbon atoms, e.g., a methyl group and a propyl group can be exemplified.

The cycloalkyl group represented $R_2$ and $R_3$ is preferably a cycloalkyl group having from 5 to 15 carbon atoms, e.g., a cyclopentyl group, a cyclohexyl group, and a cyclooctyl group can be exemplified.

The alkenyl group represented $R_2$ and $R_3$ is preferably an alkenyl group having from 2 to 9 carbon atoms, e.g., a vinyl group, a propenyl group, and allyl group can be exemplified.

The alkynyl group represented $R_2$ and $R_3$ is preferably an alkynyl group having from 2 to 9 carbon atoms, e.g.,

an ethynyl group, a propynyl group, and a butynyl group can be exemplified.

The aryl group represented $R_2$ and $R_3$ is preferably an aryl group having from 6 to 15 carbon atoms, e.g., a phenyl group can be exemplified.

The alkylene chains in these groups may have a hetero atom such as an oxygen atom or a sulfur atom.

As the substituents that each group represented by $R_2$ and $R_3$ may have, a hydroxyl group, a halogen atom, an aromatic ring (preferably having from 3 to 15 carbon atoms), a carboxyl group, and an amino group can be exemplified.

The alkyl group represented by $R_4$ and $R_5$ is preferably an alkyl group having from 1 to 8 carbon atoms, e.g., a methyl group and an ethyl group can be exemplified.

The acyl group represented by $R_4$ and $R_5$ is preferably an acyl group having from 2 to 9 carbon atoms, e.g., a methylcarbonyl group can be exemplified.

As the substituents that each group represented by $R_4$ and $R_5$ may have, a hydroxyl group, an amino group and a halogen atom can be exemplified.

In formula (1), it is preferred that either $R_4$ or $R_5$ does not represent a hydrogen atom.

In formula (1), it is especially preferred that $R_1$ represents a single bond and $R_2$ and $R_4$ represent a hydrogen atom. In this case $R_3$ represents a hydrogen atom, a halogen atom, a carboxyl group, an alkyl group, a cycloalkyl group, an alkenyl group, an alkynyl group, or an aryl group, and especially preferably a hydrogen atom or an alkyl group. $R_5$ represents a hydrogen atom, a halogen atom, a carboxyl group, an alkyl group, or an acyl group, and especially preferably an alkyl group. As the substituents that the alkyl group represented by $R_3$ may have, a hydroxyl group, a carboxyl group and an amino group are preferred. As the substituents that the alkyl group represented by $R_5$ may have, a hydroxyl group and an amino group are preferred.

In formula (2), the alkylene group represented by $R_6$ and $R_{10}$ may be any of straight chain, branched, or cyclic, and preferably an alkylene group having from 1 to 8 carbon atoms, e.g., a methylene group and an ethylene group can be exemplified.

As the substituents that the alkylene group and the phenylene group may have, a hydroxyl group and a halogen atom can be exemplified.

The alkyl group represented by $R_7$ and $R_8$ is preferably an alkyl group having from 1 to 8 carbon atoms, e.g., a methyl group and a propyl group can be exemplified.

The cycloalkyl group represented by $R_7$ and $R_8$ is preferably a cycloalkyl group having from 5 to 15 carbon atoms, e.g., a cyclopentyl group, a cyclohexyl group and a cyclooctyl group can be exemplified.

The alkenyl group represented by $R_7$ and $R_9$ is preferably an alkenyl group having from 2 to 9 carbon atoms, e.g., a vinyl group, a propenyl group and an allyl group can be exemplified.

The alkynyl group represented by $R_7$ and $R_8$ is preferably an alkynyl group having from 2 to 9 carbon atoms, e.g., an ethynyl group, a propynyl group and a butynyl group can be exemplified.

The aryl group represented by $R_7$ and $R_8$ is preferably an aryl group having from 6 to 15 carbon atoms, e.g., a phenyl group can be exemplified.

The alkylene chains in these groups may have a hetero atom such as an oxygen atom or a sulfur atom.

As the substituents that each group represented by $R_7$ and $R_8$ may have, a hydroxyl group, a halogen atom, and an aromatic ring (preferably having from 3 to 15 carbon atoms) can be exemplified.

The alkyl group represented by Rg is preferably an alkyl group having from 1 to 8 carbon atoms, e.g., a methyl group and an ethyl group can be exemplified.

The acyl group represented by $R_9$ is preferably an acyl group having from 2 to 9 carbon atoms, e.g., a methylcarbonyl group can be exemplified.

The alkylene chains in these groups may have a hetero atom such as an oxygen atom or a sulfur atom.

As the substituents that each group represented by $R_9$ may have, a hydroxyl group, an amino group, a halogen atom, and a carboxyl group can be exemplified.

In formula (2), $R_9$ is preferably not a hydrogen atom.

The specific examples of the compounds represented by formula (1) and formula (2) are shown below, but it should not be construed that the invention is limited thereto.

TABLE 1

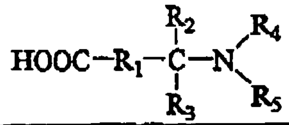

(1)

| | $R_1$ | $R_2$ | $R_3$ | $R_4$ | $R_5$ |
|---|---|---|---|---|---|
| A-1 | — | $-H$ | $-H$ | $-H$ | $-CH_3$ |
| A-2 | — | $-H$ | $-H$ | $-H$ | $-CH_2OH$ |
| A-3 | — | $-H$ | $-H$ | $-CH_2OH$ | $-CH_2OH$ |
| A-4 | — | $-H$ | $-H$ | $-H$ | $-CH_2CH_2OH$ |
| A-5 | — | $-H$ | $-H$ | $-CH_2CH_2OH$ | $-CH_2CH_2OH$ |
| A-6 | — | $-H$ | $-CH_3$ | $-H$ | $-CH_2OH$ |
| A-7 | — | $-H$ | $-CH_3$ | $-CH_2CH_2OH$ | $-CH_2CH_2OH$ |
| A-8 | — | $-H$ | $-CH_2OH$ | $-H$ | $-CH_2OH$ |
| A-9 | — | $-H$ | $-CH(CH_3)_2$ | $-CH_2OH$ | $-CH_2OH$ |
| A-10 | — | $-H$ | $-Ph$ | $-H$ | $-(CH_2CH_2O)_2-H$ |
| A-11 | — | $-H$ | 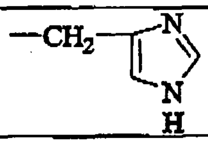 | $-CH_2CH_2OH$ | $-CH_2CH_2OH$ |
| A-12 | — | $-H$ | $-CH_2SCH_3$ | $-CH_2CH_2OH$ | $-CH_2CH_2OH$ |
| A-13 | — | $-H$ | $-H$ | $-H$ | $-COCH_2NH_2$ |
| A-14 | — | $-H$ | $-CH_2OH$ | $-H$ | $-COCH_2NH_2$ |
| A-15 | — | $-H$ | $-H$ | $-H$ | $-COCH_3$ |
| A-16 | $-CH_2-$ | $-H$ | $-H$ | $-CH_2CH_2OH$ | $-CH_2CH_2OH$ |
| A-17 | $-CH_2-$ | $-H$ | $-H$ | $-H$ | $-CH_2OH$ |
| A-18 | $-CH_2-$ | $-H$ | $-H$ | $-H$ | $-COCH_2NH_2$ |
| A-19 | $-CH_2CH_2-$ | $-H$ | $-H$ | $-H$ | $-H$ |
| A-20 | — | $-H$ | $-CH_3$ | $-H$ | $-CH_2CH_2OH$ |
| A-21 | — | $-H$ | $-CH_3$ | $-H$ | $-CH_2OH$ |
| A-22 | — | $-H$ | $-CH_2CH_3$ | $-H$ | $-CH_2CH_2OH$ |
| A-23 | — | $-H$ | $-CH_3$ | $-H$ | $-CH_2OH$ |
| A-24 | — | $-H$ | $-CH_3$ | $-H$ | $-CH_2CH_2NH_2$ |
| A-25 | — | $-H$ | $-CH_2(CH_3)_2$ | $-H$ | $-CH_2CH_2OH$ |
| A-26 | — | $-H$ | phenyl group | $-H$ | $-CH_2CH_2OH$ |
| A-27 | — | $-H$ | $-H$ | $-H$ | $-(CH_2)_3OH$ |

TABLE 2

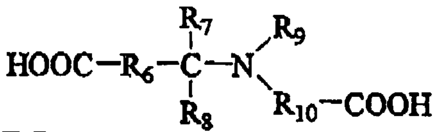

(2)

| | $R_6$ | $R_7$ | $R_8$ | $R_9$ | $R_{10}$ |
|---|---|---|---|---|---|
| B-1 | — | $-H$ | $-H$ | $-CH_2$ | $-CH_2-$ |
| B-2 | — | $-H$ | $-H$ | $-CH_2OH$ | $-CH_2-$ |
| B-3 | — | $-H$ | $-H$ | $-CH_2CH_2OH$ | $-CH_2-$ |
| B-4 | — | $-H$ | $-H$ | $-(CH_2CH_2O)_{10}H$ | $-CH_2-$ |
| B-5 | — | $-H$ | $-CH_3$ | $-H$ | $CH_3$<br>$-CH-$ |
| B-6 | — | $-H$ | $-CH_2OH$ | $-H$ | $CH_2OH$<br>$-CH-$ |
| B-7 | $-CH_2-$ | $-H$ | $-H$ | $-H$ | $-CH_2-$ |
| B-8 | $-CH_2-$ | $-H$ | $-H$ | $-H$ | $-CH_2CH_2-$ |
| B-9 | $-CH_2-$ | $-H$ | $-H$ | $-CH_2CH_2OH$ | $-CH_2CH_2-$ |
| B-10 | $-CH_2-$ | $-H$ | $-H$ | $-CH_2COOH$ | $-CH_2-$ |
| B-11 | — | $-H$ | $-CH_3$ | $-H$ | $-CH_2CH_2-$ |

The compound represented by formula (1) or (2) can be synthesized according to well-known methods but commercially available products may be used.

The addition amount of the compound represented by formula (1) or (2) is preferably from 0.0005 to 5 mols as the total amount in 1 liter of the polishing liquid for metals to be used in polishing, and more preferably from 0.01 to 0.5 mols.

It is preferred to use both the compounds represented by formulae (1) and (2) in combination. In this case, the proportion of the compound represented by formula (1)/the compound represented by formula (2) is generally from 100/1 to 1/100 as mass ratio, and preferably from 10/1 to 1/10.

Compound having aromatic ring:

Further, it is preferred that the polishing liquid for metals contains a compound having an aromatic ring.

The compound having an aromatic ring is a compound having an aromatic ring such as a benzene ring or a naphthalene ring, and preferably having from 20 to 600 molecular weight, e.g., tetrazoles and derivatives thereof, anthranilic acids and derivatives thereof, aminotoluic acid, quinaldinic acid, and azoles as shown below are exemplified.

As the azoles as the compound having an aromatic ring, benzimidazole-2-thiol, 2-[2-(benzothiazolyl)] thiopropionic acid, 2-[2-(benzothiazolyl)]thiobutyric acid, 2-mercaptobenzothiazole, 1,2,3-triazole, 1,2,4-triazole, 3-amino-1H-1,2,4-triazole, benzotriazole, 1-hydroxybenzotriazole, 1-dihydroxypropylbenzotriazole, 2,3-dicarboxypropylbenzotriazole, 4-hydroxybenzotriazole, 4-carboxyl-1H-benzotriazole, 4-methoxycarbonyl-1H-benzotriazole, 4-butoxycarbonyl-1H-benzotriazole, 4-octyloxyrcarbonyl-1H-benzotriazole, 5-hexylbenzotriazole, N-(1,2,3-benzotriazolyl-1-methyl)-N-(1,2,4-triazolyl-1-methyl)-2-ethylhexylamine, tolyltriazole, naphthotriazole, and bis[(1-benzotriazolyl)-methyl] phosphonic acid are exemplified, and benzotriazole, 4-hydroxybenzotriazole, 4-carboxyl-1H-benzotriazole butyl ester, tolyltriazole and naphthotriazole are preferred to reconcile a high CMP rate with a low etching rate.

As the compound having an aromatic ring in the invention, it is especially preferred to contain at least one compound selected from tetrazoles and derivatives thereof, and anthranilic acids and derivatives thereof.

As the tetrazoles and derivatives thereof, a compound represented by the following formula (I) is preferred, and as the anthranilic acids and derivatives thereof, a compound represented by the following formula (II) is preferred.

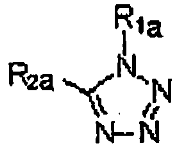 (I) 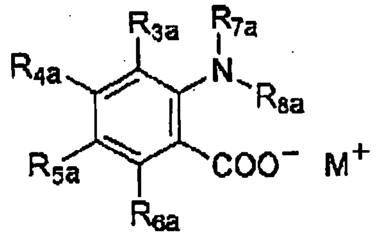 (II)

In formula (I), $R_{1a}$ and $R_{2a}$ each independently represents a hydrogen atom or a substituent. $R_{1a}$ and $R_{2a}$ may be bonded to each other to form a ring. When $R_{1a}$ and $R_{2a}$ represent a hydrogen atom at the same time, the compound represented by formula (I) may be the tautomers thereof.

In formula (II), $R_{3a}$, $R_{4a}$, $R_{5a}$, $R_{6a}$, $R_{7a}$ and $R_{8a}$ each independently represents a hydrogen atom or a substituent. Of $R_{3a}$ to $R_{6a}$, contiguous two may be bonded to each other to form a ring. $M^+$ represents a cation.

The substituents of the groups represented by $R_{1a}$ and $R_{2a}$ in formula (I) are not especially restricted and, for example, the following groups are exemplified.

A halogen atom (e.g., a fluorine atom, a chlorine atom, a bromine atom, and iodine atom), an alkyl group (e.g., a straight chain, branched or cyclic alkyl group, which may be a polycyclic alkyl group such as a bicycloalkyl group, or may contain an active methine group), an alkenyl group, an alkynyl group, an aryl group, a heterocyclic group (the position of substitution is not restricted), an acyl group, an alkoxycarbonyl group, an aryloxycarbonyl group, a heterocyclic oxycarbonyl group, a carbamoyl group (as a carbamoyl group having a substituent, e.g., an N-hydroxycarbamoyl group, an N-acylcarbamoyl group, an N-sulfonylcarbamoyl group, an N-carbamoylcarbamoyl group, a thiocarbamoyl group, an N-sulfamoylcarbamoyl group), a carbazoyl group, a carboxyl group or salts thereof, an oxalyl group, an oxamoyl group, a cyano group, a carbonimidoyl group, a formyl group, a hydroxyl group, an alkoxyl group (including a group containing an ethyleneoxy group unit or a propyleneoxy group unit repeatedly), an aryloxy group, a heterocyclic oxy group, an acyloxy group, an (alkoxy or aryloxy) carbonyloxy group, a carbamoyloxy group, a sulfonyloxy group, an amino group, an (alkyl, aryl or heterocyclic)amino group, an acylamino group, a sulfonamido group, a ureido group, a thioureido group, an N-hydroxyureido group, an imido group, an (alkoxy or aryloxy)carbonylamino group, a sulfamoylamino group, a semicarbazide group, a thiosemicarbazide group, a hydrazino group, an ammonio group, an oxamoylamino group, an N-(alkyl or aryl)sulfonylureido group, an N-acylureido group, an N-acylsulfamoylamino group, a hydroxylamino group, a nitro group, a heterocyclic group containing a quaternized nitrogen atom (e.g., a pyridinio group, an imidazolio group, a quinolinio group, an isoquinolinio group), an isocyano group, an imino group, a mercapto group, an (alkyl, aryl, or heterocyclic) thio group, an (alkyl, aryl, or heterocyclic)- dithio group, an (alkyl or aryl)sulfonyl group, an (alkyl or aryl) sulfinyl group, a sulfo group or a salt thereof, a sulfamoyl group (as a sulfamoyl group having a substituent, e.g., an N-acylsulfamoyl group, an N-sulfonylsulfamoyl group), or a salt thereof, a phosphino group, a phosphinyl group, a phosphinyloxy group, a phosphinylamino group, and a silyl group are exemplified.

The active methine group means a methine group substituted with two electron attractive groups. The electron attractive groups mean, e.g., an acyl group, an alkoxycarbonyl group, an aryloxycarbonyl group, a carbamoyl group, an alkylsulfonyl group, an arylsulfonyl group, a sulfamoyl group, a trifluoromethyl group, a cyano group, a nitro group, and a carbonimidoyl group. Two electron attractive groups may be bonded to each other to take a cyclic structure. The salts mean cations of alkaline metals, alkaline earth metals and heavy metals, and organic cations such as ammonium ion and phosphonium ion.

Of the above substituents, preferred substituents are, e.g., a halogen atom (e.g., a fluorine atom, a chlorine atom, a bromine atom, and iodine atom), an alkyl group (e.g., a straight chain, branched or cyclic alkyl group, which may be a polycyclic alkyl group such as a bicycloalkyl group, or may contain an active methine group), an alkenyl group, an alkynyl group, an aryl group, a heterocyclic group (the position of substitution is not restricted), an acyl group, an alkoxycarbonyl group, an aryloxycarbonyl group, a heterocyclic oxycarbonyl group, a carbamoyl group, an N-hydroxycarbamoyl group, an N-acylcarbamoyl group, an N-sulfonylcarbamoyl group, an N-carbamoylcarbamoyl group, a thiocarbamoyl group, an N-sulfamoyl carbamoyl group, a carbazoyl group, an oxalyl group, an oxamoyl group, a cyano group, a carbonimidoyl group, a formyl group, a hydroxyl group, an alkoxyl group (including a group containing an ethyleneoxy group unit or a propyleneoxy group unit repeatedly), an aryloxy group, a heterocyclic oxy group, an acyloxy group, an (alkoxy or aryloxy)carbonyloxy group, a carbamoyloxy group, a sulfonyloxy group, an (alkyl, aryl or heterocyclic) amino group, an acylamino group, a sulfonamido group, a ureido group, a thioureido group, an N-hydroxyureido group, an imido group, an (alkoxy or aryloxy)carbonylamino group, a sulfamoyl- amino group, a semicarbazide group, a thiosemicarbazide group, a hydrazino group, an ammonio group, an oxamoylamino group, an N-(alkyl or aryl)sulfonylureido group, an N-acylureido group, an N-acylsulfamoylamino group, a hydroxyamino group, a nitro group, a heterocyclic group containing a quaternizednitrogen atom (e.g., a pyridinio group, an imidazolio group, a quinolinio group, an isoquinolinio group), an isocyano group, an imino group, a mercapto group, an (alkyl, aryl, or hetero-cyclic) thio group, an (alkyl, aryl, or heterocyclic)dithio group, an (alkyl or aryl) sulfonyl group, an (alkyl or aryl)- sulfinyl group, a sulfo group or a salt thereof, a sulfamoyl group, an N-acylsulfamoyl group, an N-sulfonylsulfamoyl group or a salt thereof, a phosphino group, a phosphinyl group, a phosphinyloxy group, a phosphinylamino group, and a silyl group. The active methine group means a methine group substituted with two electron attractive groups. The electron attractive groups mean, e.g., an acyl group, an alkoxycarbonyl group, an aryloxycarbonyl group, a carbamoyl group, an alkylsulfonyl group, an arylsulfonyl group, a sulfamoyl group, a trifluoro- methyl group, a cyano group, a nitro group, and a carbonimidoyl group.

More preferred substituents are a halogen atom (a fluorine atom, a chlorine atom, a bromine atom, and iodine atom), an alkyl group (a straight chain, branched or cyclic alkyl group, which may be a polycyclic alkyl group such as a bicycloalkyl group, or may contain an active methine group), an alkenyl group, an alkynyl group, an aryl group, and a heterocyclic group (the position of substitution is not restricted).

The ring formed by bonding of $R_{1a}$ and $R_{2a}$ with a -C-N-bond in formula (I) may be a monocyclic ring or a polycyclic ring, preferably a 5- or 6-membered monocyclic ring, or a polycyclic ring constituted by a 5- or 6-membered ring.

The above substituents may further be substituted with the above substituents.

The molecular weight of the compound represented by formula (I) is preferably from 20 to 600, more preferably from 40 to 400.

The specific examples of the compounds represented by formula (I) are shown below, but the invention is not limited thereto.

I-1
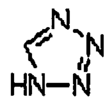
I-2
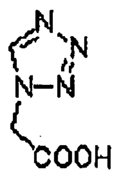
I-3
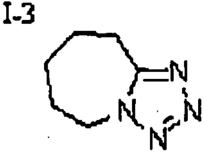

I-4
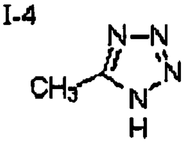
I-5
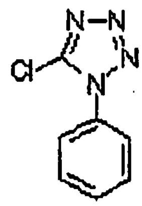
I-6
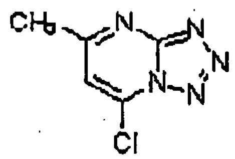

I-7
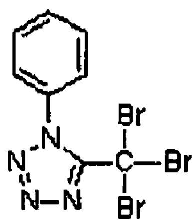
I-8
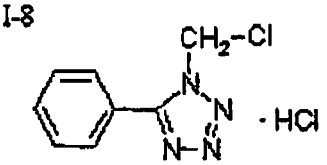
I-9
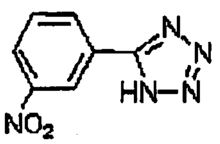

I-10
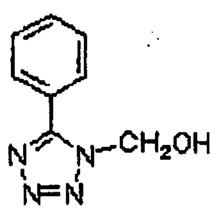
I-11
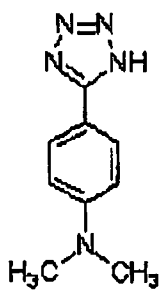
I-12
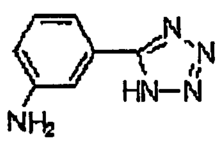

I-13
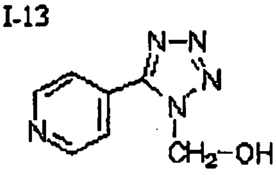
I-14
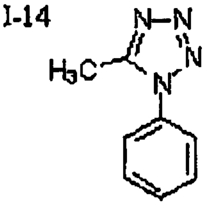
I-15
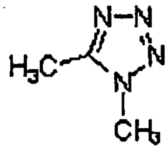
I-16
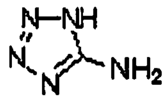

I-17
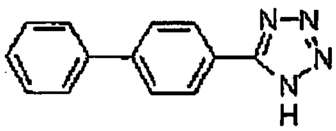
I-18
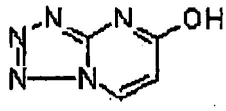
I-19
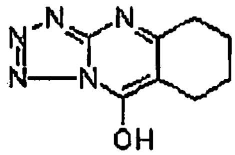

I-20
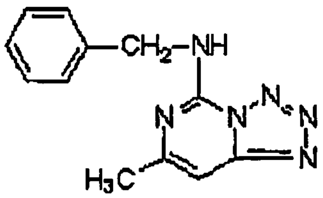
I-21
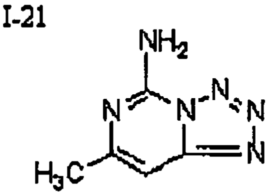
I-22
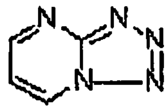

I-23
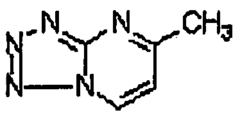
I-24
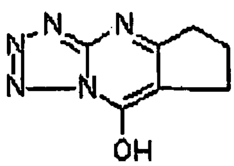
I-25
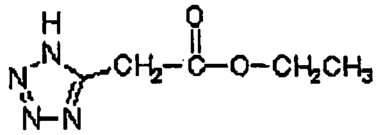

I-26
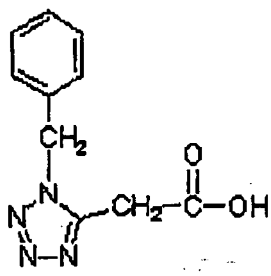
I-27
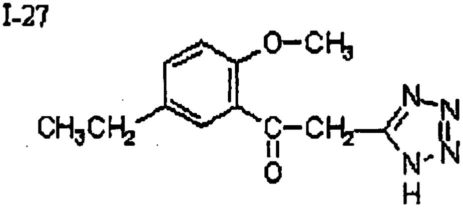

I-28
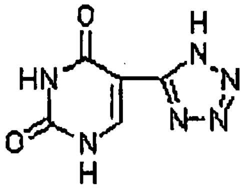
I-29
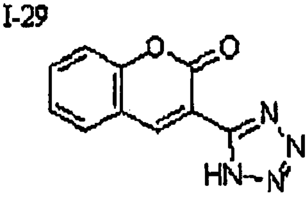

I-30

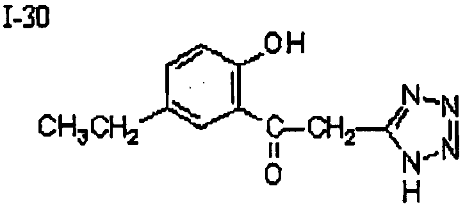

I-31

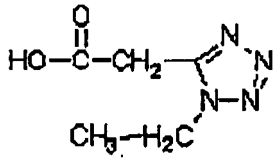

I-32

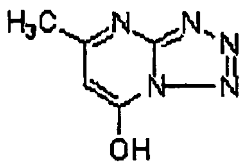

I-33

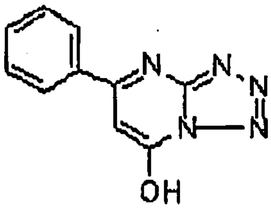

I-34

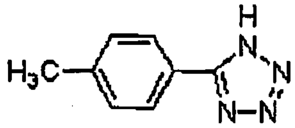

I-35

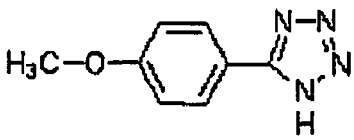

I-36

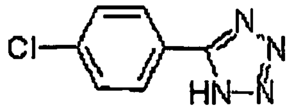

I-37

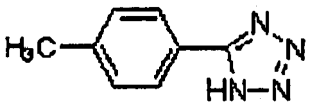

I-38

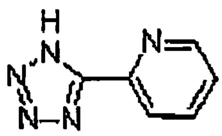

I-39

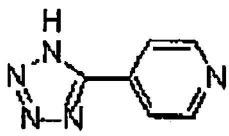

I-40

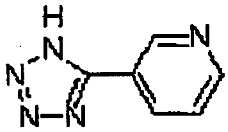

I-41

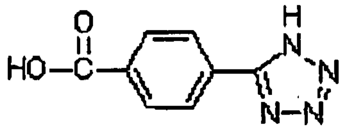

I-42

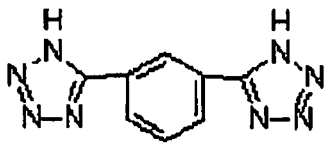

I-43

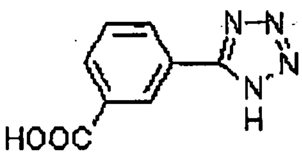

I-44

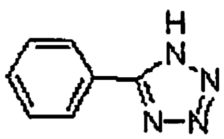

I-45

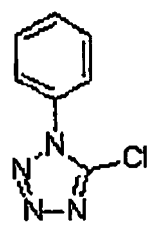

I-46

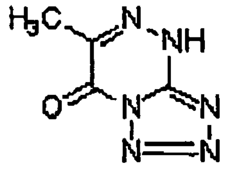

I-47

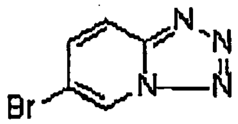

I-48

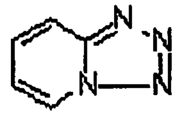

I-49

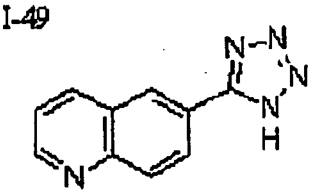

I-50

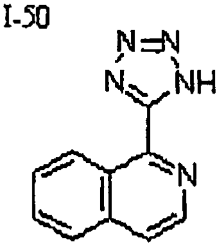

I-51

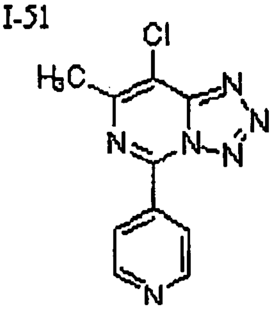

Of the compounds represented by formula (I), Compounds I-1, I-3, I-4, 1-10, I-15, I-21, 1-22, I-23, I-41 and I-48 are preferred, and Compounds I-1, I-4, I-15, I-22 and I-23 are more preferred.

The compounds represented by formula (I) may be used alone, or two or more compounds may be used in combination.

The compounds represented by formula (I) can be synthesized according to ordinary methods, but commercially available products may be used.

The substituents of the groups represented by $R_{3a}$ to $R_{8a}$ are not especially restricted and, for example, the following groups are exemplified.

A halogen atom (e.g., a fluorine atom, a chlorine atom, a bromine atom, and iodine atom), an alkyl group (e.g., a straight chain, branched or cyclic alkyl group, which may be a polycyclic alkyl group such as a bicycloalkyl group, or may contain an active methine group), an alkenyl group, an alkynyl group, an aryl group, a heterocyclic group (the position of substitution is not restricted), an acyl group, an alkoxycarbonyl group, an aryloxycarbonyl group, a heterocyclic oxycarbonyl group, a carbamoyl group (as a carbamoyl group having a substituent, e.g., an N-hydroxycarbamoyl group, an N-acylcarbamoyl group, an N-sulfonyloarbamoyl group, an N-carbamoylcarbamoyl group, a thiocarbamoyl group, an N-sulfamoylcarbamoyl group), a carbazoyl group, a carboxyl group or salts thereof, an oxalyl group, an oxamoyl group, a cyano group, a carbonimidoyl group, a formyl group, a hydroxyl group, an alkoxyl group (including a group containing an ethyleneoxy group unit or a propyleneoxy group unit repeatedly), an aryloxy group, a heterocyclic oxy group, an acyloxy group, an (alkoxy or aryloxy) carbonyloxy group, a carbamoyloxy group, a sulfonyloxy group, an amino group, an (alkyl, aryl or heterocyclic)amino group, an acylamino group, a sulfonamido group, a ureido group, a thioureido group, an N-hydroxyureido group, an imido group, an (alkoxy or aryloxy)carbonylamino group, a sulfamoylamino group, a semicarbazide group, a thiosemicarbazide group, a hydrazino group, an ammonio group, an oxamoylamino group, an N-(alkyl or aryl)sulfonylureido group, an N-acylureido group, an N-acylsulfamoylamino group, a hydroxylamino group, a nitro group, a heterocyclic group containing a quaternized nitrogen atom (e.g., a pyridinio group, an imidazolio group, a quinolinio group, an isoquinolinio group), an isocyano group, an imino group, a mercapto group, an (alkyl, aryl, or heterocyclic) thio group, an (alkyl, aryl, or heterocyclic)- dithio group, an (alkyl or aryl)sulfonyl group, an (alkyl or aryl) sulfinyl group, a sulfo group or a salt thereof, a sulfamoyl group (as a sulfamoyl group having a substituent, e.g., an N-acylsulfamoyl group, an N-sulfonylsulfamoyl group), or a salt thereof, a phosphino group, a phosphinyl group, a phosphinyloxy group, a phosphinylamino group, and a silyl group are exemplified.

The active methine group means a methine group substituted with two electron attractive groups. The electron attractive groups mean, e.g., an acyl group, an alkoxycarbonyl group, an aryloxycarbonyl group, a carbamoyl group, an alkylsulfonyl group, an arylsulfonyl group, a sulfamoyl group, a trifluoromethyl group, a cyano group, a nitro group, and a carbonimidoyl group. Two electron attractive groups may be bonded to each other to take a cyclic structure. The salts mean cations of alkaline metals, alkaline earth metals and heavy metals, and organic cations such as ammonium ion and phosphonium ion.

These substituents may further be substituted with these substituents.

As preferred substituents of these, at least one of $R_{3a}$ to $R_{6a}$ represents a substituent not having a substituent other than an alkyl group, more preferably $R_{7a}$ and $R_{8a}$ each represents a hydrogen atom, and especially preferably at least one of $R_{3a}$ to $R_{6a}$ represents the above electron attractive group and $R_{7a}$ and $R_{8a}$ each represents a hydrogen atom.

The cation represented by $M^+$ is not especially restricted and, e.g., a hydrogen ion, an alkaline metal ion (e.g., $Na^+$, $K^+$, $L^+$, etc.), an ammonium ion (e.g., $NH4^+$, a quaternary ammonium ion, etc.) can be exemplified.

The molecular weight of the compound represented by formula (II) is preferably from 20 to 600, more preferably from 40 to 400.

The specific examples of the compounds represented by formula (II) are shown below, but the invention is not restricted thereto.

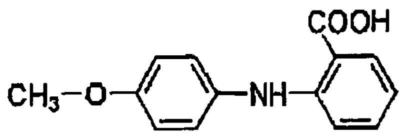
II-1

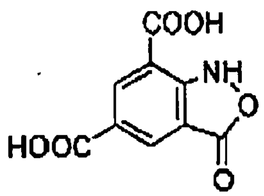
II-2

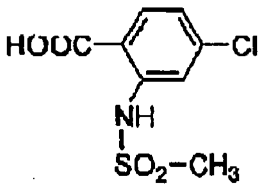
II-3

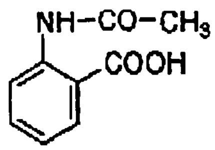
II-4

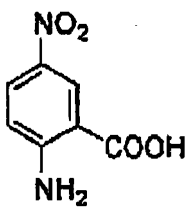
II-5

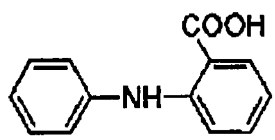
II-6

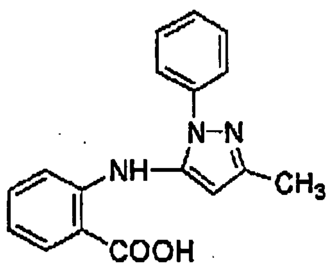
II-7

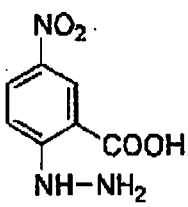
II-8

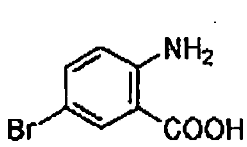
II-9

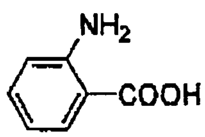
II-10

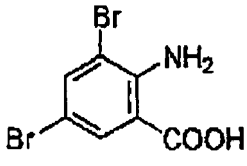

II-11

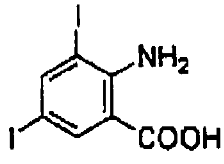

II-12

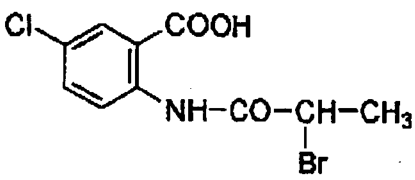

II-13

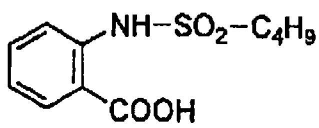

II-14

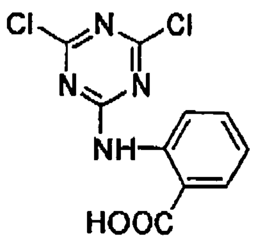

II-15

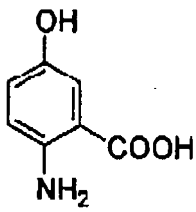

II-16

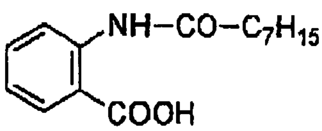

II-17

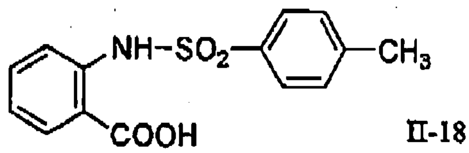

II-18

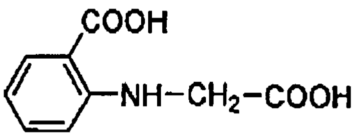

II-19

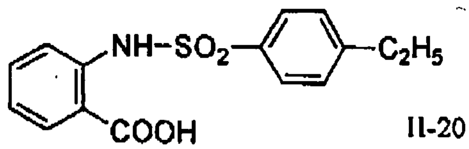

II-20

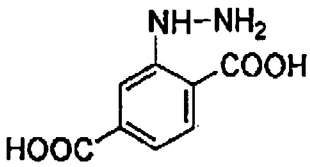

II-21

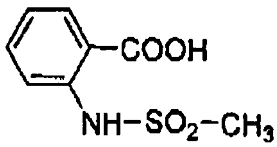

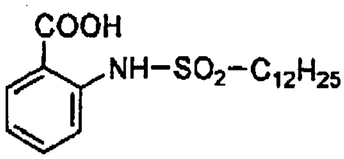

II-23

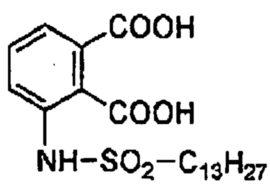

II-24

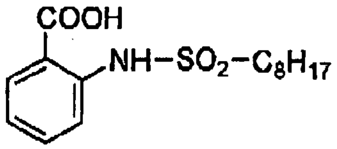
II-25

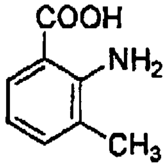
II-26

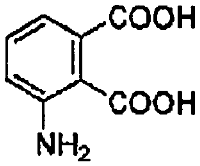
II-27

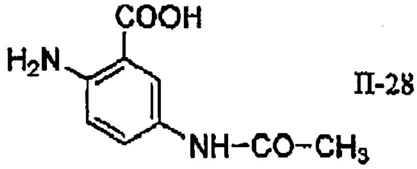
II-28

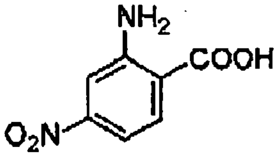
II-29

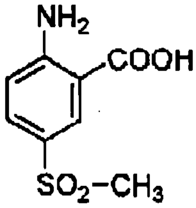
II-30

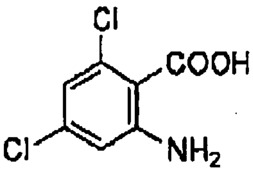
II-31

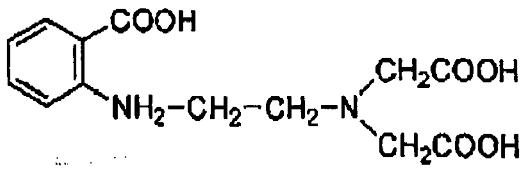
II-32

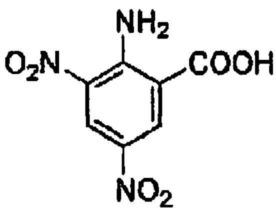
II-33

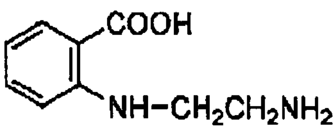
II-34

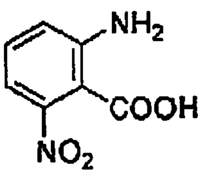
II-35

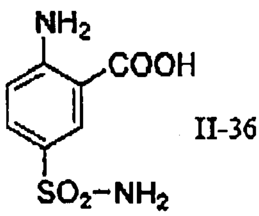
II-36

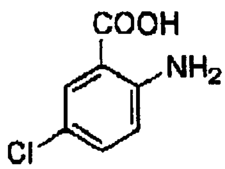
II-37

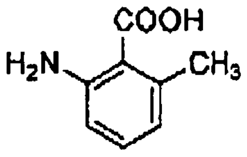 II-38 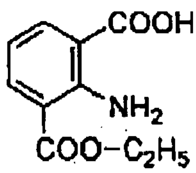 II-39

Of the compounds represented by formula. (II), Compounds II-2, II-5, II-9, II-27, II-29, II-30, II-33, II-35 and II-37 are preferred, and Compounds II-5, II-9, II-27, II-29 and II-33 are especially preferred.

Further, the above exemplified compounds in which the hydrogen atom of the carboxyl group is substituted with an alkaline metal ion, e.g., $Na^+$, $K^+$ or $L^+$, or an ammonium ion, e.g. , NH4$^+$ or a quaternary ammonium ion, to make a salt thereof can be exemplified.

The compounds represented by formula (II) may be used alone, or two or more compounds may be used in combination.

As the compounds represented by formula (II), commercially available products may be used, or may be synthesized according to ordinary methods.

For example, Compound II-29 can be synthesized according to the synthesizing method described in Synthesis (8), pp. 654-659 (1983). Compound II-37 can be synthesized according to the methods described in Tetrahedron Letters, 51 (7), pp. 1861-1866 (1995) and Tetrahedron Letters, 44 (25), pp. 4741-4745 (2003). Other compounds can also be synthesized according to the methods described in these literatures.

The addition amount of the compound having an aromatic ring, e.g., tetrazoles and derivatives thereof or anthranilic acids and derivatives thereof, is preferably from 0.0001 to 1.0 mol as the total amount in 1 liter of the polishing liquid for metals to be used in polishing (that is, in the case where a polishing liquid is diluted with water or an aqueous solution, "the polishing liquid for metals to be used in polishing" is a polishing liquid after dilution, hereinafter the same), more preferably from 0.001 to 0.5 mol, and still more preferably from 0.01 to 0.1 mol.

That is, the addition amount of the compound having an aromatic ring is preferably 1.0 mol or less in 1 liter of the polishing liquid for metals to be used in polishing from the aspect of the prevention of the oxidant and these compounds (nullification, decomposition), and preferably 0.0001 mol or more for obtaining sufficient effect.

Incidentally, thiocyanates, thioethers, thiosulfates or meso-ionic compounds may be used in combination in the addition amount smaller than the addition amount of tetrazoles and derivatives thereof or anthranilic acids and derivatives thereof.

Acid:

The polishing liquid in the invention can further contain an acid. The acid here is a compound different in structure from the oxidant for oxidizing metals, and does not include acids that function as the above oxidants, and the compounds represented by formula (1) or (2). The acid here functions to accelerate oxidation, adjust pH, or as a buffer.

As the examples of the acids, in this range, e.g., inorganic acids, organic acids and amino acids are exemplified.

As the inorganic acids, sulfuric acid, nitric acid, boric acid and phosphoric acid are exemplified, and phosphoric acid is preferred of the inorganic acids.

In the invention, it is preferred that organic acids and amino acids are present, and amino acids are especially preferred.

The organic acids are preferably water-soluble. Organic acids selected from the following group are more preferred, e.g., formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid adipic acid, pimelic acid, maleic acid, phthalic acid, malic acid, tartaric acid, citric acid, lactic acid, ammonium salts and alkaline metal salts of these acids, in addition, sulfuric acid, nitric acid, ammonia, ammonium salts, and mixtures of them. Of these acids, formic acid, malonic acid, malic acid, tartaric acid and citric acid are suitable for laminated film containing at least one kind of metal layer selected from copper, a copper alloy, and oxides of copper or a copper alloy.

Amino acids are preferably water-soluble. Amino acids selected from the following group are more preferred.

Glycine, L-alanine, β-alanine, L-2-aminobutyric acid, L-norvaline, L-valine, L-leucine, L-norleucine, L-isoleucine, L-alloisoleucine, L-phenylalanine, L-proline, sarcosine, L-ornithine, L-lysine, taurine, L-serine, L-threonine, L-allothreonine, L-homoserine, L-tyrosine, 3,5-diiodo-L-tyrosine, β-(3,4-dihydroxyphenyl)-L-alanine, L-thyroxine, 4-hydroxy-L-proline, L-cysteine, L-methionine, L-ethionine, L-lanthionine, L-cystathionine, L-cystine, L-cysteic acid, L-aspartic acid, L-glutamic acid, S-(carboxymethyl)-L-cysteine, 4-aminobutyric acid, L-asparagine, L-glutamine, azaserine, L-arginine, L-canavanine, L-citrulline, δ-hydroxy-L-lysine, creatine, L-kynurenine, L-histidine, 1-methyl-L-histidine, 3-methyl-L-histidine, ergothioneine, L-tryptophane, actinomycin C1, apamine, angiotensin I, angiotensin II, and antipine.

Especially, malic acid, tartaric acid, citric acid, glycine and glycolic acid are preferred for the reason that an etching rate can be effectively controlled while maintaining a practical CMP rate.

The addition amount of an acid is preferably from 0.0005 to 0.5 mol in 1 liter of the polishing liquid for metals to be used in polishing, more preferably from 0.005 to 0.3 mol, and especially preferably from 0.01 to 0.1 mol. That is, the addition amount of an acid of 0 .5 mol or less is preferred from the point of the controlling of etching and 0.0005 mol or more is preferred for obtaining sufficient effect.

Chelating agent:

It is preferred for the polishing liquid for metals in the invention to contain a chelating agent (that is, a water softener) according to necessity to decrease adverse influence by a polyvalent metal to be mixed.

The chelating agents are general purpose water softeners that are suspending agents of calcium and magnesium and analogous compounds, e.g., nitrilotriacetic acid, diethylenetriaminepentaacetic acid, ethylenediaminetetraacetic acid, N,N,N-trimethylenephosphonic acid, ethylenediamine-N,N,N' ,N'-tetramethylenesulfonic acid, transcyclohexanediaminetetraacetic acid, 1,2-diaminopropane-tetraacetic acid, glycol ether diamine tetraacetic acid, ethylenediamine-orthohydroxyphenylacetic acid, ethylenediaminesuccinic acid (SS body), N-(2-carboxylatoethyl)-L-aspartic acid, β-alaninediacetic acid, 2-phosphonobutane-1,2,4-tricarboxylic acid, 1-hydroxyethylidene-1,1-diphosphonic acid, N,N' -bis (2-hydroxybenzyl)ethylenediamine-N,N'-diacatic acid, and 1,2-dihydroxybenzene-4,6-disulfonic acid are exemplified.

Two or more chelating agents may be used in combination, if necessary.

The addition amount of the chelating agent should be sufficient to sequester metal ions such as polyvalent metal ions mixed, for example, it is added in an amount of from 0.0003 to 0.07 mol in 1 liter of the polishing liquid for metals to be used in polishing.

Additives:

It is also preferred for the polishing liquid for metals in the invention to contain the following additives.

Ammonia; alkylamine, e.g., dimethylamine, trimethylamine, triethylamine, and propylenediamine, amines, e.g., ethylenediaminetetraacetic acid (EDTA), sodium diethyldithiocarbamate and chitosan; imines, e.g., dithizone, cuproine (2,2'-biquinoline), neocuproine(2,9-dimethyl-1,10-phenanthroline), basocuproine-(2,9-dimethyl-4,7-diphenyl-1,10-phenanthroline), and cuperazone(biscyclohexanoneoxalylhydrazone); and mercaptan, e.g., nonyl-mercaptan, dodecylmercaptan, triazinethiol, triazinedithiol, and triazinetrithiol.

Of these compounds, chitosan, ethylenediaminetetraacetic acid, L-tryptophane, cuperazone and triazinethiol are preferably used to reconcile a high CMP rate with a low etching rate.

The addition amount of these additives is preferably from 0.0001 to 0.5 mol in 1 liter of the polishing liquid for metals to be used in polishing, more preferably from 0.002 to 0.3 mol, and especially preferably from 0.005 to 0.1 mol. That is, the addition amount of additives of 0.0001 mol or more is preferred from the point of the controlling of etching and 0.5 mol or less is preferred for the prevention of reduction of the CMP rate.

Surfactant and/or hydrophilic polymer:

It is preferred for the polishing liquid for metals in the invention to contain a surfactant and/or a hydrophilic polymer. A surfactant and a hydrophilic polymer both have a function of reducing the contact angle of the surface polished and accelerating uniform polishing. The surfactants and/or hydrophilic polymers selected from the following group are preferably used.

As anionic surfactants, carboxylates, sulfonates, sulfates and phosphates are exemplified. As carboxylates, soap, N-acylamino acid salt, polyoxyethylene or polyoxypropylene alkyl ether carboxylate, and acylated peptide; as sulfonates, alkylsulfonate, alkylbenzene and alkylnaphthalenesulfonates, sulfosuccinate, α-olefinic sulfonate, and N-acylsulfonate; as sulfates, sulfated oil, alkyl sulfate, alkyl ether sulfate, polyoxyethylene or polyoxypropylene alkylallyl ether sulfate, and alkylamide sulfate; as phosphates, alkylphosphate, and polyoxyethylene or polyoxypropylene alkylallyl ether phosphate can be exemplified.

As cationic surfactants, aliphatic amine salts, aliphatic quaternary ammonium salts, benzalkonium chloride salt, benzethonium chloride, pyridinium salt, and imidazolinium salt; as amphoteric surfactants, carboxy betaine, aminocarboxylate, imidazolinium betaine, lecithin, and alkylamine oxide can be exemplified.

As nonionic surfactants, an ether type, an ether ester type, an ester type, and a nitrogen-containing type are exemplified. As ether types, polyoxyethylene alkyl and alkylphenyl ether, alkylallyl-formaldehyde condensation polyoxyethylene ether, polyoxyethylene-polyoxypropylene block copolymer, and polyoxyethylene polyoxypropylene alkyl ether;

as ether ester types, polyoxyethylene ether of glycerol ester, polyoxyethylene ether of sorbitan ester, and polyoxyethylene ether of sorbitol ester; as ester types, polyethylene glycol fatty acid ester, glycerol ester, polyglycerol ester, sorbitan ester, propylene glycol ester, and sucrose ester; and as nitrogen-containing types, fatty acid alkanolamide, polyoxyethylene fatty acid amide, and polyoxyethylene alkylamide are exemplified.

Fluorine surfactants are also exemplified.

In addition, as other surfactants, hydrophilic compounds and hydrophilic polymers, the following compounds can be exemplified. Esters, e.g., glycerol ester, sorbitan ester, methoxyacetic acid, 3-ethoxypropionic acid and alanine ethyl ester; ethers, e.g., polyethylene glycol, polypropylene glycol, polytetramethylene glycol, polyethylene glycol alkyl ether, polyethylene glycol alkenyl ether, alkylpolyethylene glycol, alkylpolyethylene glycol alkyl ether, alkylpolyethylene glycol alkenyl ether, alkenylpolyethylene glycol, alkylpolyethylene glycol alkyl ether, alkenylpolyethylene glycol alkenyl ether, polypropylene glycol alkyl ether, polypropylene glycol alkenyl ether, alkylpolypropylene glycol, alkylpolypropylene glycol alkyl ether, alkylpolypropylene glycol alkenyl ether, alkenylpolypropylene glycol, alkenylpolypropylene glycol alkyl ether, and alkenylpolypropylene glycol alkenyl ether; polysaccharides and salts thereof, e.g., alginic acid, pectic acid, carboxymethyl cellulose, curdlan, and pullulan; amino acid salts, e.g., glycine ammonium salt and glycine sodium salt; polycarboxylic acids, e.g., polyaspartic acid, polyglutamic acid, polylysine, polymalic acid, polymethacrylic acid, ammonium polymethacrylate, sodium polymethacrylate, polyamide acid, polymaleic acid, polyitaconic acid, polyfumaric acid, poly(p-styrene- carboxylic acid), polyacrylic acid, polyacrylamide, aminopolyacrylamide, ammonium polyacrylate, sodium polyacrylate, polyamide acid, ammonium polyamide acid salt, sodium polyamide acid salt, and polyglyoxylic acid; vinyl polymers, e.g., polyvinyl alcohol, polyvinyl pyrrolidone, and polyacrolein; sulfonic acid and salts thereof, e.g., ammonium methyl taurate, sodium methyl taurate, sodium methyl sulfate, ammonium ethyl sulfate, ammonium butyl sulfate, sodium vinyl sulfonate, sodium 1-allyl sulfonate, sodium 2-allyl sulfonate, sodium methoxymethyl sulfonate, ammonium ethoxymethyl sulfonate, sodium 3-ethoxypropyl sulfonate, sodium methoxymethyl sulfonate, ammonium ethoxymethyl sulfonate, sodium 3-ethoxypropyl sulfonate, and sodium sulfosuccinate; and amides, e.g., propionamide, acrylamide, methylurea, nicotinamide, succinic amide, and sulfanyl amide.

However, when the substrate to be polished is a silicon substrate for semiconductor integrated circuit and the like, contamination by alkaline metal, alkaline earth metal and halogenide is not preferred, acids or ammonium salts thereof are used in such a case. This, however, does not apply to the case where the substrate is glass. Of the exemplified compounds, cyclohexanol, ammonium polyacrylate, polyvinyl alcohol, succinic amide, polyvinyl pyrrolidone, polyethylene glycol, and polyoxyethylene-polyoxypropylene block copolymer are more preferred.

The addition amount of surfactants and/or hydrophilic polymers is preferably from 0.001 to 10 g in 1 liter of the polishing liquid for metals to be used in polishing, more preferably from 0.01 to 5 g, and especially preferably from 0.1 to 3 g. That is, for obtaining sufficient effect, the addition amount of surfactants and/or hydrophilic polymers is preferably 0.001 g or more, and for the prevention of reduction of the CMP rate, 10 g or less is preferred. In addition, the weight average molecular weight of these surfactants and/or hydrophilic polymers is preferably from 500 to 100,000, and especially preferably from 2,000 to 50,000.

<u>Alkali agent and buffer:</u>

The polishing liquid in the invention can contain, if necessary, an alkali agent for the adjustment of pH, and a buffer for the restraint of the fluctuation of pH.

As the alkali agent and the buffer, nonmetal alkali agents such as organic ammonium hydroxide, e.g., ammonium hydroxide and tetramethylammonium hydroxide; alkanolamines, e.g., diethanolamine, triethanolamine and triisopropanolamine; alkaline metal hydroxide, e.g., sodium hydroxide, potassium hydroxide, and lithium hydroxide; carbonate, phosphate, borate, tetraborate, hydroxybenzoate, glycyl salt, N,N-dimethylglycine salt, leucine salt, norleucine salt, guanine salt, 3,4-dihydroxyphenylalanine salt, alanine salt, aminobutyrate, 2-amino-2-methyl-1,3-propanediol salt, valine salt, proline salt, trishydroxyaminomethane salt, and lysine salt can be used.

As the specific examples of alkali agents and buffers, sodium hydroxide, potassium hydroxide, lithium hydroxide, sodium carbonate, potassium carbonate, sodium bicarbonate, potassium bicarbonate, trisodium phosphate, tripotassium phosphate, disodium phosphate, dipotassium phosphate, sodium borate, potassium borate, sodium tetraborate (borax), potassium tetraborate, sodium o-hydroxybenzoate (sodium salicylate), potassium o-hydroxybenzoate, sodium 5-sulfo-2-hydroxybenzoate (sodium 5-sulfosalicylate), potassium 5-sulfo-2-hydroxybenzoate (potassium5-sulfosalicylate), and ammonium hydroxide can be exemplified.

Particularly preferred alkali agents are ammonium hydroxide, potassium hydroxide, lithium hydroxide and tetramethylammonium hydroxide.

The addition amount of the alkali agent and buffer is sufficient so long as pH is maintained in a preferred range, and the amount is preferably from 0.0001 to 1.0 mol in 1 liter of the polishing liquid for metals to be used in polishing, and more preferably from 0.003 to 0.5 mol.

The pH of the polishing liquid in polishing is preferably from 2 to 14, more preferably from 3 to 12, and most

preferably from 3.5 to 8. When pH is in this range, the polishing liquid in the invention exhibits especially excellent effect.

It is preferred in the invention to arbitrarily determine the kinds and addition amounts of compounds and pH according to the adsorptivity and reactivity of the liquid to the surface to be polished, the solubility of polishing metals, the electrochemical properties of the surface polished, the dissociation conditions of the functional groups of the compounds, and the stability of the liquid.

Of the components to be added in manufacturing the concentrated liquid of a polishing liquid for metals, the blending amount of a component having solubility in water at room temperature of less than 5% is preferably within 2 times the solubility in water at room temperature for preventing precipitation when the concentrated liquid is cooled to 5°C, more preferably within 1.5 times.

Abrasive grains:

It is preferred for the polishing liquid for metals in the invention to contain abrasive grains. As preferred abrasive grains, e.g., silica (precipitated silica, fumed silica, colloidal silica, synthetic silica), ceria, alumina, titania, zirconia, germania, manganese oxide, silicon carbide, polystyrene, polyacryl and polyterephthalate are exemplified, and colloidal silica is especially preferred.

The average grain size of abrasive grains is preferably from 5 to 1,000 nm, and especially preferably from 10 to 200 nm.

The addition amount of abrasive grains is preferably from 0.01 to 20 mass% based on the total mass of the polishing liquid for metals to be used in polishing, and more preferably from 0.05 to 5 mass%. The addition amount of 0.01 mass% or more is preferred for obtaining sufficient effects in the improvement of polishing rate and in the reduction of the fluctuation of polishing rate of in-plane of wafer, and 20 mass% or less is preferred for the saturation of polishing rate by CMP.

When the polishing liquid does not contain abrasive grains or contains in concentration of less than 0.01 mass%, the polishing rate and dishing characteristics are improved by making pH 3.5 or more, especially 4.0 or more. In this case, it is preferred to contain the above hydrophilic polymers, e.g., polyacrylic acid, and the addition amount is generally from 0.0001 to 5 mass%, and preferably from 0.01 to 0.5 mass%.

Wiring metal material:

In the invention, it is preferred that a semiconductor that is the object of polishing is LSI having wiring comprising a copper metal and/or a copper alloy, and a copper alloy is especially preferred. Of copper alloys, those containing silver is preferred. The silver content in a copper alloy is preferably 40 mass% or less, more preferably 10 mass% or less, and especially preferably 1 mass% or less. The most excellent effects can be exhibited when the silver content in a copper alloy is from 0.00001 to 0.1 mass%.

Thickness of wiring:

In the invention, a semiconductor that is the object of polishing is preferably LSI having wiring thickness as half pitch of 0.15 μm or less in a DRAM device system, mroe preferably 0.10 μm or less, and especially preferably 0.08 μm or less, on the other hand in an MPU device system, 0.12 μm or less, more preferably 0. 09 μm or less, and especially preferably 0.07μ m or less. The polishing liquid in the invention exhibits excellent effect especially to these LSI.

Barrier metal:

In the invention, it is preferred to provide a barrier layer between the wiring comprising a copper metal and/or a copper alloy and the layer insulation film to prevent diffusion of copper. As the barrier layer, low resisting metal materials are preferred, e.g., TiN, TiW, Ta, TaN, W, WN and Ru are preferred, and Ta and TaN are preferred above all.

Polishing method:

As the preparing methods of a polishing liquid for metals, there are a case where a polishing liquid is prepared as a concentrated liquid and diluted with water for use, a case where each component is prepared as an aqueous solution as described below and mixed and diluted, if necessary, to prepare a working liquid, and a case where a polishing liquid is prepared as a working liquid. The polishing method using the polishing liquid for metals according to the invention can apply to any case, which is a polishing method of feeding a polishing liquid to a polishing pad on a platen, bringing into contact with the surface to be polished, and performing polishing by the relative movement of the surface to be polished and the polishing pad.

As polishers, generally used polishers having a platen having a holder to hold a semiconductor substrate having the surface to be polished and a polishing pad stuck (equipped with a motor whose engine speed is variable) can be used. As a polishing pad, common nonwoven fabrics, foamed polyurethane and porous fluorine resins can be used, and not especially restricted. Polishing conditions are not limited, but it is preferred that the rotation of a platen is low rotation of 200 rpm or less so that the substrate does not sprint out. The pressure of pressing a semiconductor substrate having the surface to be polished (a layer to be polished) against a polishing pad is preferably from 5 to 500 g/$cm^2$, and more preferably from 12 to 240 g/$cm^2$ for satisfying the uniformity of in-plane of wafer of a polishing rate and the flatness of pattern.

During polishing, the polishing liquid for metals is continuously fed to the polishing pad with a pump. The feed amount is not restricted but it is preferred that the surface of the polishing pad is always covered with the polishing liquid. The semiconductor substrate after polishing is thoroughly washed in flowing water, water droplets on the surface of the semiconductor substrate are blown off with a spin drier and the like, and dried. In the polishing method in the invention, an aqueous solution for dilution is the same as the following described aqueous solution. The aqueous solution is water containing one or more of an oxidant, an acid, additives, and a surfactant in advance, and the total components of the components contained in the aqueous solution and the components in the polishing liquid for metals to be diluted are made to be equal to the components of the polishing liquid for use in polishing. When a polishing liquid is used after dilution with the aqueous solution, a difficultly soluble component can be blended in the form of an aqueous solution, so that a more concentrated polishing liquid for metals can be prepared.

For adding water or an aqueous solution to a concentrated polishing liquid for metals, a method of joining the piping for feeding a concentrated polishing liquid for metals and the piping for feeding water or an aqueous solution en route to mix both liquids, and feeding the mixed and diluted polishing liquid for metals to a polishing pad is known. As the mixing method, ordinarily used methods can be used, e.g., a method of passing the liquids through a narrow passage with pressure and impinging and mixing the liquids, a method of filling piping with fillers such as glass tubes to separate and combine the flow of the liquids repeatedly, and a method of providing blades rotating with motive power in piping can be used.

The feed rate of the polishing liquid for metals is preferably from 10 to 1,000 ml/min, and for satisfying uniformity of polishing rate of the in-plane of wafer and flatness of pattern, from 170 to 800 ml/min is more preferred.

As the polishing method by diluting a concentrated polishing liquid for metals with water or an aqueous solution, a method for use in the invention comprises providing piping for feeding a polishing liquid for metals and piping for feeding water or an aqueous solution independently, feeding prescribed amounts of respective liquids to a polishing pad, and performing polishing while mixing the liquids by the relative movement of the polishing pad and the surface to be polished. Alternatively, a prescribed amount of a concentrated polishing liquid for metals, and water or an aqueous solution are put in one container, and the mixed polishing liquid for metals is fed to a polishing pad to perform polishing.

As further method, the components of the polishing liquid for metals are divided into at least two constituents, the constituents are diluted with water or an aqueous solution and fed to a polishing pad on a platen at the time of use, and the polishing pad and the surface to be polished are brought into contact and polishing may be performed by the relative movement of the polishing pad and the surface to be polished.

For example, taking an oxidant as one constituent (A), and an acid, additives, a surfactant and water as one constituent (B), and constituent (A) and constituent (B) are diluted with water or an aqueous solution at the time of use.

Alternatively, additives low in solubility are divided into two constituents (A) and (B), an oxidant, additives and a surfactant are made as one constituent (A), an acid, additives, a surfactant and water are made as one constituents (B), and constituent (A) and constituents (B) are diluted with water or an aqueous solution at the time of use. In this case, three piping are necessary to feed respectively constituent (A), constituents (B), and water or an aqueous solution. Dilution mixture may be performed in one piping fed to a polishing pad joined with three piping, and in this case, it is possible to join two piping and then join with another one piping.

For example, constituents containing difficultly soluble additives are mixed with other constituents, a mixing route is made long to ensure the time for dissolution, and further piping of water or an aqueous solution is joined. As other mixing method, a method of directly leading three piping to a polishing pad and mixing the constituents by the relative movement of the polishing pad and the surface to be polished as described above, and a method of mixing three constituents in one container and feeding the diluted polishing liquid for metals to a polishing pad can be used. In the above polishing method, when one constituent containing an oxidant is made 40°C or less, another constituent is heated in the range of from room temperature to 100°C, and one constituent and another constituent are mixed or diluted by adding water or an aqueous solution for use, the temperature can be made 40°C or less after mixing. Since solubility becomes high at high temperature, this is preferred method to increase the solubility of materials of a polishing liquid for metals having low solubility.

The material obtained by dissolving other component not containing an oxidant by heating in the range of from room temperature to 100°C is precipitated in the solution when the temperature lowers, so that when the component lowered in temperature is used, it is necessary to dissolve the precipitate in advance by heating. For this purpose, a

means of feeding the liquid of the component dissolved by heating, and a means of stirring the liquid containing the precipitate in advance, and feeding the liquid while heating the piping to thereby dissolve the precipitate can be adopted. There is the possibility of decomposition of oxidant when one component wherein the heated component contains oxidant is heated at 40°C or more, accordingly, when the heated component and one component containing an oxidant to cool the heated component are mixed, the temperature should be 40°C or less.

Further, in the invention, as described above, the components of the polishing liquid for metals may be divided into two or more portions and fed to the surface to be polished. In this case, it is preferred to divide the components into a portion containing an oxidant and a portion containing an acid. In addition, a polishing liquid for metals is made concentrated liquid and dilution water is fed differently to the surface to be polished.

Pad:

Pads for polishing may a pad of non-foamed structure or a pad of foamed structure. The former uses a bulk material of hard synthetic resin such as a plastic plate. There are three types of closed-cell foam (dry foam), open-cell foam (wet foam), and two-layer composite (lamination) in the latter type, and two-layer composite (lamination) is especially preferred. Foam may be uniform or non-uniform.

Further, the pad may contain abrasive grains used in polishing (e.g., ceria, silica, alumina, resins). Hardness of the pad may be either hard or soft, and it is preferred that the lamination type be composed of different hardness. As the materials of the pad, nonwoven fabric, artificial leather, polyamide, polyurethane, polyester and polycarbonate are preferably used. The surface of the pad in contact with the surface to be polishedmay be processed with grooves of lattices, holes, concentric grooves, and spiral grooves.

Wafer:

A wafer that is the object of CMP with the polishing liquid for metals in the invention is preferably a wafer having a diameter of 200 mm or more, and especially preferably 300 mm or more. The effect of the invention is conspicuously exhibited when the diameter of a wafer is 300 mm or more.

EXAMPLES

The invention will be described with reference to Examples, but it should not be construed that the invention is limited thereto.

Polishing test:

Substrate: A silicon substrate having formed a copper film having a thickness of 1 μm
Polishing pad: IC1400 (Rhodel)
Polisher: BC-15 (manufactured by MAT)
Presser bar pressure: 14,000 Pa
Feeding rate of polishing liquid: 50 ml/min
Wafer size: 60 mm x 60 mm
Rate of relative movement of polishing pad/wafer: 1.0 m/s (average rate of relative movement of wafer in-plane)

Evaluation method:

CMP moving rate:

The average polishing rate was obtained in terms of the electric resistance value of the film thickness of the metal film before and after CMP at 17 points on the surface of the wafer.

Measuring instrument: DC four-probe sheet resistance
measuring instrument VR-120 (manufactured by Hitachi Kokusai Electric Inc.)

Dishing:

A commercially available pattern wafer was polished and the dishing amount of 100 μm wiring part on the

wafer was measured.

Polished object: 854 Mask Pattern Wafer (manufactured by Sematech)
Measuring instrument: Contact type measuring instrument of difference in level P-15 (manufactured by KLA-Tencor, Japan)

Taking the time required to bare the barrier surface as 100%, the time corresponding to 120% (20% over-polishing) was taken as the polishing time.

Preparation of polishing liquid for metals:

Solvent: Super pure water
Oxidant: Hydrogen peroxide (manufactured by Wako Pure Chemical Industries)
Compound: 0.1 mol/liter (shown in Table 3 below)
Abrasive grains: Colloidal silica 0.15 mass% (PL-3, manufactured by Fuso Kagaku)
pH: 7.0 (adjusted with aqueous ammonia or nitric acid)

With respect to each polishing liquid comprising 0.1 mol/liter of the compound shown in Table 3 below and the concentration of oxidant changed as shown in Table 3, the polishing time and dishing were measured as described above. The results obtained are shown in Table 3.

TABLE 3

| | | Copper Film Polishing Rate (nm/min) | | | | | Dishing (nm) | | | | |
|---|---|---|---|---|---|---|---|---|---|---|---|
| | | Concentration of Oxidant (wt%) | | | | | Concentration of Oxidant (wt%) | | | | |
| Polishing Solution | Compound | 0.3 | 0.5 | 1.0 | 2.0 | 5.0 | 0.3 | 0.5 | 1.0 | 2.0 | 5.0 |
| 1 | Glycine | 320 | 610 | 850 | 1,020 | 420 | 150 | - | 300 | - | 180 |
| 2 | EDTA | 40 | 150 | 310 | 130 | 60 | - | - | 210 | 180 | - |
| 3 | Malic Acid | 80 | 150 | 270 | 150 | 60 | 120 | - | 250 | 190 | - |
| 4 | A-1 | 100 | 140 | 280 | 360 | 60 | 80 | - | 100 | 60 | - |
| 5 | A-4 | | 310 | 390 | 310 | | 200 | - | 200 | 120 | - |
| 6 | A-5 | 310 | 440 | 390 | 290 | 230 | 100 | - | 160 | 50 | - |
| 7 | A-13 | 290 | 400 | 550 | 430 | 320 | 180 | - | 260 | 80 | - |
| 8 | B-1 | 540 | 690 | 870 | 630 | 330 | 80 | - | 150 | 20 | - |
| 9 | B-3 | 470 | 680 | 620 | 490 | 340 | 80 | - | 120 | 40 | - |

It can be seen from the results shown in Table 3 that the polishing liquids containing the compound represented by formula (I) or (II) are small in dishing on the condition of high concentration of oxidant (2.0 mass%).

Two-step polishing test:

The polishing liquid shown in Table 4 below was used. Taking the polishing amount required to bare the barrier surface as 100%, the amount corresponding to 70% was polished with the polishing liquid having the concentration of oxidant in the first step, and the remaining 30% and over-polishing by 20% were polished with the polishing liquid having the concentration of oxidant in the second step.

TABLE 4

| Liquid Solution | Compound | Concentration of Oxidant (wt%) | | Polishing Time (sec) | Dishing (nm) |
|---|---|---|---|---|---|
| | | 1st step | 2nd Step | | |
| 1 | Glycine | 2.0 | 5.0 | 101 | 190 |
| 2 | EDTA | 1.0 | 2.0 | 329 | 200 |
| 3 | Malic acid | 1.0 | 2.0 | 331 | 200 |
| 4 | A-1 | 2.0 | 5.0 | 500 | 60 |
| 5 | A-4 | 1.0 | 2.0 | 199 | 120 |
| 6 | A-5 | 1.0 | 2.0 | 204 | 50 |
| 7 | A-13 | 1.0 | 2.0 | 142 | 100 |
| 8 | B-1 | 1.0 | 2.0 | 92 | 50 |
| 9 | B-3 | 1.0 | 2.0 | 125 | 70 |

In the above two-step polishing (n=2), according to the method satisfying $R_{n-1}>R_n$ with respect to polishing rate $R_n$, and $C_{n-1}<C_n$ with respect to oxidant concentration $C_n$, taking the oxidant concentration in the first step as equal, it can be seen that dishing performance is better than that in one-step polishing shown in Table 3. It is also seen that the systems capable of reconciling the polishing time with the reduction of dishing are present.

This application is based on Japanese Patent application JP 2005-83471, filed March 23, 2005, the entire content of which is hereby incorporated by reference, the same as if set forth at length.

## Claims

1. A polishing method comprising chemically and mechanically polishing a surface to be polished, the polishing comprising a plurality of steps, wherein the surface is polished with a polishing liquid containing an oxidant in each of the plurality of steps, and the polishing liquids used for the each of the steps are different only in a concentration of the oxidant and satisfy the following expression (1):

$$R_{n-1} > R_n \qquad (1)$$

wherein $R_n$ represents a polishing rate of the surface to be polished in $n^{th}$ step, $R_{n-1}$ represents a polishing rate of the surface to be polished in $n\text{-}1^{th}$ step, and n represents an integer of 2 or more.

2. The polishing method as claimed in claim 1, wherein the polishing liquids used for the each of the steps satisfy the following expression (2):

$$C_{n-1} < C_n \qquad (2)$$

wherein $C_n$ represents a concentration of the oxidant in the $n^{th}$ step, and $C_{n-1}$ represents a concentration of the oxidant in the $n\text{-}1^{th}$ step.

3. The polishing method as claimed in claim 1, wherein the oxidant is one of hydrogen peroxide, peroxide, nitrate, iodate, periodate, hypochlorite, chlorite, chlorate, perchlorate, persulfate, dichromate, permanganate, ozone water, silver(II) salt, and iron(III) salt.

4. The method as claimed in claim 1, wherein the polishing liquid contains at least one of a compound represented by the following formula (1) and a compound represented by the following formula (2):

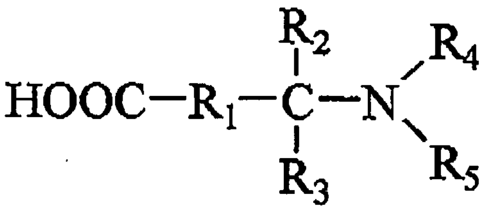

(1)

wherein $R_1$ represents a single bond, an alkylene group or a phenylene group; $R_2$ and $R_3$ each independently represents a hydrogen atom, a halogen atom, a carboxyl group, an alkyl group, a cycloalkyl group, an alkenyl group, an alkynyl group, or an aryl group; $R_4$ and $R_5$ each independently represents a hydrogen atom, a halogen atom, a carboxyl group, an alkyl group, or an acyl group; provided that when $R_1$ represents a single bond, at least one of $R_4$ and $R_5$ does not represent a hydrogen atom;

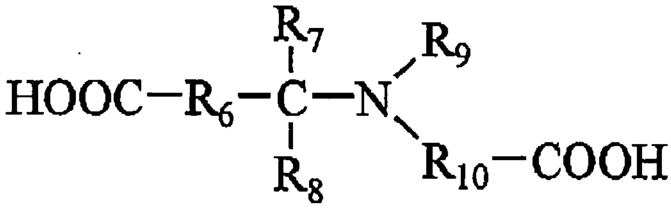

(2)

wherein $R_6$ represents a single bond, an alkylene group or a phenylene group; $R_7$ and $R_8$ each independently represents a hydrogen atom, a halogen atom, a carboxyl group, an alkyl group, a cycloalkyl group, an alkenyl group, an alkynyl group, or an aryl group; $R_9$ represents a hydrogen atom, a halogen atom, a carboxyl group, or an alkyl group; $R_{10}$ represents an alkylene group; provided that when $R_{10}$ represents $-CH_2-$, $R_6$ does not represent a single bond, or $R_9$ does not represent a hydrogen atom.

5. The polishing method as claimed in claim 1, wherein the polishing liquid further contains an abrasive grain.

6. The polishing method as claimed in claim 1, wherein the surface to be polished is a surface containing at least one compound selected from a compound containing copper, a compound containing a copper alloy and a compound containing tantalum.

7. A polishing liquid not containing an oxidant for use in the polishing method as claimed in claim 1.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002064070 A
- US 6599173 B
- JP 11345792 A
- JP 2001257188 A
- JP 2005083471 A


### Non-patent literature cited in the description


- Rikagaku Jiten. Iwanami Shoten Publishers
- *Synthesis,* 1983, (8), 654-659
- *Tetrahedron Letters,* 1995, vol. 51 (7), 1861-1866
- *Tetrahedron Letters,* 2003, vol. 44 (25), 4741-4745